# NEW EUROPEAN PATENT SPECIFICATION

(11) **EP 0 287 383 B2**
(45) Date of publication and mention of the opposition decision: **21.08.2002**
(45) Mention of the grant of the patent: 24.03.1993
(21) Application number: 88303404.3
(22) Date of filing: 15.04.1988
(51) Int. Cl.: H01L 39/24

(54) **Superconducting ceramic film and a method of manufacturing the same**
Supraleitender keramischer Film und Verfahren zu dessen Herstellung
Couche en céramique supraconductrice et procédé de fabrication

(30) Priority: 15.04.1987 JP 9373287; 15.04.1987 JP 9373387
(43) Date of publication of application: 19.10.1988
(73) Proprietor: SEMICONDUCTOR ENERGY LABORATORY CO., LTD., Atsugi-shi Kanagawa-ken 243-0036 (JP)
(72) Inventor: Yamazaki, Shunpei, Tokyo 157 (JP)
(74) Representative: Milhench, Howard Leslie

(56) References cited:
- EP-A- 0 292 387
- JP-A- 5 889 875
- US-A- 3 346 425
- PROCEEDINGS OF SYMPOSIUM S, EXTENDED ABSTRACTS OF HIGH TC SUPERCONDUCTORS, SPRING MEETING OF THE MATERIALS RESEARCH SOCIETY, 23rd-24th April 1987, pages 81-84, Anaheim, California, US; R.H. KOCH et al.: "Thin films and squids made from YBa2Cu3Oy"
- "International Conference on Ion Beam Modification of Materials", 4-8 September 1978, Budapest (HU), Proceedings, vol.III, Ed.: J. Gyulai et al, ISBN 963 371 519 9, J.Y. Robic et al.: "Ion Implantation in Superconducting Niobium and Nb3Sn-thin films: Adjustment of Josephson Microbridges and SQUID", pages 2061 - 2070
- "IEEE Transactions on Magnetics", vol. MAG-11, no. 2, March 1975, pages 785-788
- "IEEE Transactions on Magnetics", vol MAG-13, no. 1, Jan. 1977, pages 724-730
- "Manufacture of Superconducting Materials" - Proceedings of an International Conference, 8-10 Nov. 1976, Port Chester, New York (US), Ed.: R.W. Meyerhoff, Materials/Metalworking Technology Series, American Society for Metals, Metals Park, Ohio, 1977, pages 122-132
- "IEEE Transactions on Magnetics", vol. MAG-13, no. 1, Jan 1977, pages 731-734
- "International Conference on Applications of Ion Beams to Metals", Sandia, N. Mexico (US), 1973, Paper I.2 of Meyer et al, titled: "Ion Implantation in Superconducting Films", Verlag Plenum Press New York, 1974, pages 15-26

## Description

### BACKGROUND OF THE INVENTION

This invention relates to advances in the field of superconductors, and more particularly relates to superconducting ceramic patterns and to methods of manufacturing the same.

Conventionally, Nb-Ge metallic material (for ex-example, Nb₃Ge) or the like has been used as a superconducting material. However, the application of superconducting materials of this type is limited since a very low temperature is required in order to achieve superconductivity and therefore the running cost is very high. In addition, in recent years ceramic materials which exhibit superconducting properties have become known. However, these have been in bulk (ingot) form and as yet there has been little development of superconducting materials in thin film form.

On the other hand, semiconductor devices provided with a plurality of elements containing semiconductor integrated circuits within the same substrate are known. The development of more and more refined semiconductor integrated circuits with high operating.

Further features of the present invention are set forth in the appended claims and, together with the features abovementioned, will be well understood from consideration of the following detailed description of exemplary embodiments of the invention given with reference to the accompanying drawings. speeds has in recent years become a necessity. However, along with these refinements problems have arisen in that reliability has suffered from the heat generated in the semiconductor element and the operating speed of the heated parts has to be reduced accordingly. For these reasons it has been earnestly required to obtain improved structures using superconducting ceramics.

### SUMMARY OF THE INVENTION

According to the present invention in one of its aspects there is provided a device comprising high-Tc a superconductive copper oxide ceramic film formed on a substrate and in which at least one region of the film contains partially oxidated, ion implanted, impurity depant which provides the impurity doped region with an electrical resistivity : temperature characteristic different from that of the non-doped film so that the impurity doped region can exhibit a finite resistivity at a temperature at which the non-doped superconductive ceramic film has zero resistance, there being no ion implantation damage to the crystalline structure of the film in the impurity doped region.

The invention resides in the realisation that characteristics peculiar to relatively high Tc superconductive copper oxide ceramic films can be utilised to achieve selective lowering of the critical temperature of prescribed portions of the ceramic. We have found by experimentation that in superconductive copper oxide ceramic films Tco (the temperature at which resistance disappears) can be controlled by doping the ceramic with selected impurities which are partially oxidated in the film and then annealing the film to make good any ion implantation damage to the crystalline structure of the film. Also Tc onset (the temperature at which a drop in resistivity starts) remains substantially unchanged by the addition of such impurities. The resulting doped portions of the superconducting ceramic have a relatively broad transition temperature region between Tco and Tc onset. That is to say, by suitably doping prescribed portions of a superconducting ceramic film the portions can be transformed into regions with low Tc which are capable of functioning as resistance regions or active regions when maintained at a temperature equal to the relatively high Tc of the non-doped portions.

In representative cases, superconducting copper oxide ceramics for use in accordance with the present invention may be prepared consistent with the stoichiometric formula (A₁₋ₓBₓ)_{y}Cu_{z}O_{w}, where A is one or more elements of Groups IIIa and Vb of the Japanese Periodic Table such as the rare earth elements, B is one or more elements of Group IIa of the Japanese Periodic Table, e.g. the alkaline earth metals including beryllium and magnesium, and x=0.1-1; y=2.0-4.0, preferably 2.5-3.5; z=1.0-4.0, preferably 1.5-3.5; and w=4.0-10.0, preferably 6.0-8.0. Examples of this general formula are BiSrCaCu₂₋₃O₄₋₁₀, Y_{0.5}Bi_{0.5}Sr₁Ca₁Cu₂₋₃O₄₋₁₀, YBa₂Cu₃O₆₋₈, Bi₁Sr₁Mg_{0.5}Ca_{0.5}Cu₂₋₃O₄₋₁₀, Bi_{0.5}Al_{0.5}SrCaCu₂₋₃O₄₋₁₀. These materials can be formed on a surface by electron beam evaporation, sputtering, photo-enhanced CVD, photo-enhanced PVD, and so forth.

According to another aspect, the present invention provides a method of manufacturing a device comprising a high-Tc superconductive copper oxide ceramic film (2) formed on a substrate (1) and wherein at least one region (11) of the film has an electrical resistivity : temperature characteristic different from that of another region (10) of the film such that the first-mentioned region (11) can exhibit a finite resistivity at a temperature at which the other region (10) has zero resistance, the method comprising forming the superconductive copper oxide ceramic film (2) on the substrate (1), defining said at least one region (11) of the film, and introducing an oxidizable impurity dopant into said at least one region (11) and not into said other region (10), the doping being effected by ion implantation and being followed by thermal annealing of the film (2) in an oxidizing atmosphere to cause the dopant to be partially oxidated in the film and to make good any ion implantation damage to the crystalline structure of the film in the impurity doped region, whereby to achieve the required electrical resistivity : temperature characteristic.

In one exemplary embodiment, the invention provides a method wherein a high-Tc superconducting copper oxide ceramic film is deposited on an insulating surface for example by sputtering to produce a film 0.1 to 30 microns in thickness. Prescribed portions of the film are then removed by photolithography to leave masked areas of superconducting ceramic which may subsequently be formed into active devices such as Josephson devices and passive devices such as resistors or conductors (wiring). The masked areas are then processed to selectivly remove the mask from prescribed portions that are destined to be low Tc regions and ion implantation with impurities selected to be partially oxidated in the film is effected through the openings in the remaining mask to produce low Tc regions in the ceramic film at the prescribed portions. After ion implantation, the superconducting film is subjected to thermal treatment to make good any damage to the crystalline structure caused during ion bombardment and to remove the remaining mask.

### BRIEF DESCRIPTION OF THE DRAWINGS

Figs.1(A) to 1(C) are cross-sectional views showing the manufacturing process of a first exemplary embodiment of the present invention;
Fig.2 is a cross-sectional view showing a second exemplary embodiment of the present invention; and
Fig.3 is a graphical diagram showing the relationship between the resistivity and the temperature of superconducting ceramics in accordance with the present invention.

### DETAILED DESCRIPTION OF THE EMBODIMENTS

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups la, Ila, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

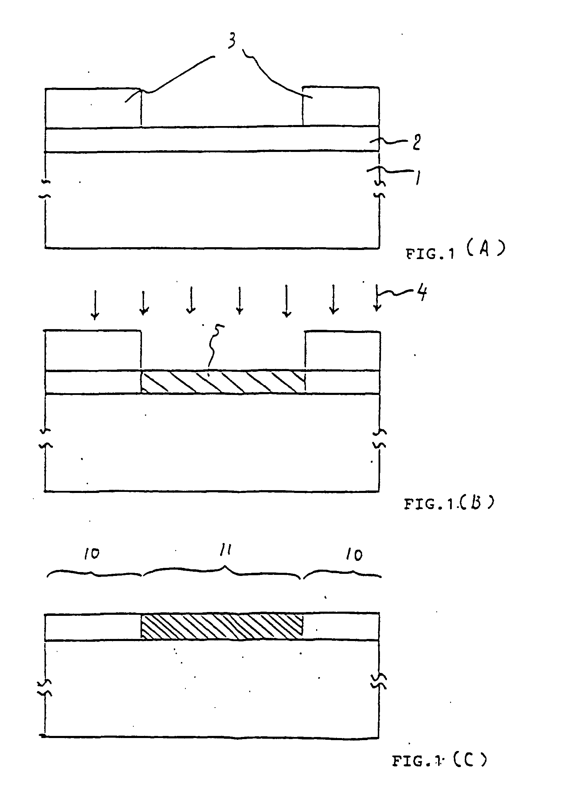

Referring to Figs.1(A) to 1(C), a method of manufacturing a superconducting ceramic pattern in accordance with the present invention will be described. In Fig.1(A), an oxide ceramic thin film 2 of 0.1 to 1.0 µm (microns) in thickness is deposited by low frequency sputtering onto an insulating single crystalline substrate 1 made of for example SrTiO₃. A sputtering target is chosen whose composition is such that a deposited complex oxide film can be grown which conforms to the stoichiometric formula (YBa₂)Cu₃O₆₋₈, and the substrate is heated in an argon-oxygen atmosphere at 700 to 1000°C, e.g. 850°C, during the sputtering process.

There will inevitably be traces of impurities such as silicon in the deposited ceramic thin film 2 and it is important that the presence of such impurities is minimised since controlled levels of impurities are added to selected portions of the film in a subsequent stage of the process in order to achieve the desired effect. By careful preparation of the sputtering target and control over the deposition of the film, the presence of impurities can be kept below an acceptable level of 100ppm and preferably not more than 10ppm.

Once the film 2 has been deposited on the substrate by sputtering, the structure is fired at 800 to 1000°C for 5-50 hours in an oxidizing atmosphere in order to transform the ceramic film into a superconducting single crystalline ceramic film. After firing, selected portions of the superconducting ceramic film 2 are covered with a photo resist mask 3 so that other unmasked portions of the film 2 can be doped with silicon by ion implantation as shown in Fig.1(B). The impurity density of the thus doped portion is 5 × 10¹⁵ to 2 × 10²² atom/cm³, e.g. 5 × 10¹⁹ atom/cm³. Thereafter, the ceramic film 2 is fired again at a temperature of from 700 to 1000°C in an oxidizing atmosphere. This thermal treatment causes oxidization of impurities in the ceramic material and therefore lowers its Tc, and at the same the resist 3 is removed from the ceramic film in the form of carbon dioxide and water. Some of the silicon implanted in the ceramic film is oxidized so that the doped portions 11 as shown in Fig.1(C) of the superconducting ceramic come to contain about 0.1% silicon oxide. The doped portion 11 of the superconducting ceramic film still contains about 99% of the original ceramic composition (i.e. 99% purity compared to that of the undoped portion 10).

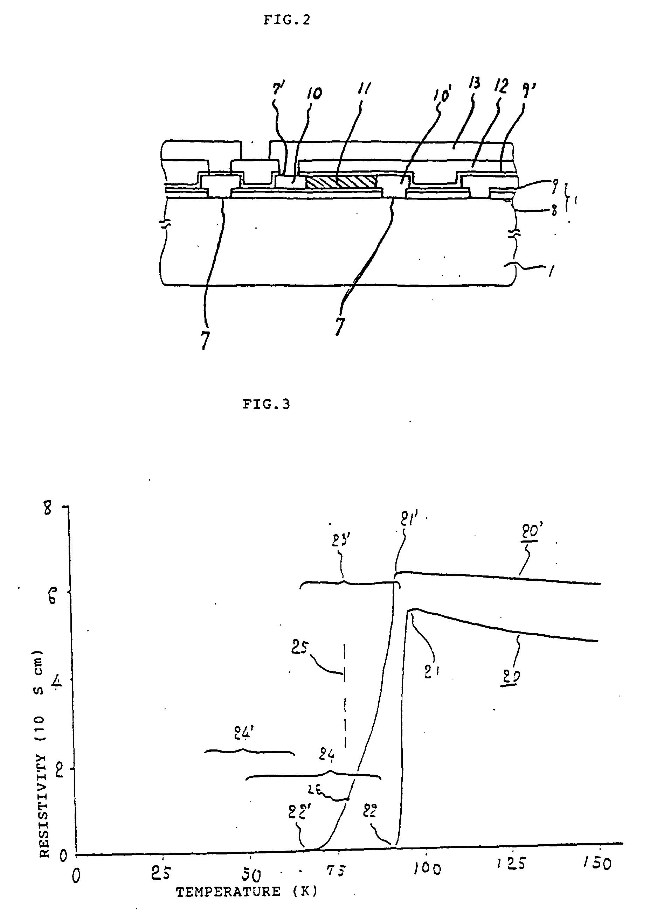

A curve 20 in Fig.3 plotted in accordance with experimentally obtained data shows the temperature resistivity relationship of the fired undoped ceramic film 10, with temperature points Tco 22 at which the resistivity vanishes and Tc onset 21 at which the resistivity starts to drop sharply. Figure 3 also shows how the resistivity-temperature relationship of the doped portions 11 of the superconducting ceramic film changes from the curve 20 to a curve 20' as a result of the doping process. As can be seen from the curve 20', Tco of the doped portion 11 shifts to a lower temperature 22' while Tc onset 21' does not change substantially. Furthermore, the difference between Tc onset and Tco increases to create a broader transition region 23'. In the illustrated case, the temperature of liquid nitrogen indicated at 25 lies within the transition region 23' and the doped portion 11 therefore has a definite resistivity 26 at the liquid nitrogen temperature 25.

The change in critical temperature of the doped portion 11 can be controlled by adjusting the amount of the doping and it has been found that the relatively low Tco of the doped portion 11 is not altered even after being subjected to a high temperature of 700 to 1000°C during the subsequent firing process.

Examples of other impurities which may be added to superconducting complex oxide ceramics in order to achieve the desired drop in Tco include Al, Mg, Ga, Ge, Ti, Zr, Fe, Hi, Co, B and P, and it is also possible to use a plurality of such impurities in combination to achieve the desired result. In any case, the doping level should be chosen to be higher than the level already occurring in the ceramic film, or alternatively an impurity that does not occur in the film may be added to the film in a suitable quantity to achieve the desired result.

Referring now to Fig. 2, another device manufactured in accordance with the present invention will hereinafter be explained. Transistors and/or other devices are formed in advance within a semiconductor substrate 1. A first insulating film 6 is then formed in a predetermined pattern on the upper surface of the substrate 1. The insulating film 6 consists of an underlying film 8 made of silicon oxide and an overlying film 9 made of silicon nitride.

In order to provide a superconducting circuit on the substrate 1, a superconducting complex oxide ceramic film is deposited on the substrate 1 over the insulating film 6 by sputtering and the deposited film is patterned by photolithography as described hereinabove in relation to the foregoing embodiment. Prescribed portions of the ceramic film are then doped with impurities by ion implantation in the same way as explained above to produce superconducting conductor areas 10 and 10' and low Tc regions 11 which can be selectively used as resistances or active regions at the temperature of liquid nitrogen. In this second embodiment, the ceramic film is subjected to lower temperatures than in the preceding embodiment during firing after ion implantation so that the final superconducting ceramic pattern has a polycrystalline structure. The devices within the semiconductor substrate co-operate with the superconducting ceramic film by virtue of being interconnected by the superconducting circuit. The manufacturing conditions of the superconducting film are selected so that at the temperature of liquid nitrogen the doped regions have a definite resistivity and the non-doped regions are superconducting.

A second insulating film 9' is formed on the substrate 1 over the films previously deposited thereon together with another insulating film 12 which fills the depressions formed by preceding deposition thereby providing an even upper surface. Openings 7' are formed in the insulating films 9' and 12 by photolithography and a second supeconducting ceramic film 13 is deposited over the insulating films 9' and 12 using the same process as in the first embodiment so that the first and the second superconducting ceramic films interconnect through the openings 7'. The second superconducting ceramic film 13 is then patterned by photolithography.

Once the ceramic film has been deposited it may then be transformed into the desired superconducting film by firing and ion implantation may then be effected. Alternatively the structure of the ceramic film may be altered by ion implantation prior to the firing transformation. In this case, the formation of low Tc regions and high Tc regions is completed after the firing.

The above described devices which include superconducting patterns in accordance with the present invention are designed to operate at the temperature of liquid nitrogen. However, if the rate of development in the field of superconductor continues as it is presently, it seems likely that it will soon be possible to construct a superconducting ceramic having a critical temperature significantly higher than the temperature of liquid nitrogen such as dry ice temperatures, and it should be appreciated that the present invention is intended to apply equally in such cases insofar as the resulting superconducting film formation comprises prescribed areas having a definite resistance at temperatures whereat other areas exhibit substantially zero resistance.

Furthermore, although in the above description the doped region of the superconducting ceramic film retains many superconducting properties at the liquid nitrogen operating temperature it should be appreciated that the invention is also intended to include a superconducting ceramic consisting of regions which have been doped so heavily that the superconducting properties of the said regions are effectively destroyed.

Although, in the above description, a semiconductor substrate provided with active devices therein is utilised, a ceramic substrate coated with a non-oxide film such as of 50 to 500 x 10⁻¹⁰m (Å) thick silicon nitride on its upper surface may instead be used. For example a YSZ (yttrium stabilized zircon) substrate may be used which has a coefficient of thermal expansion substantially the same as that of the ceramic.

Complex oxide superconducting ceramics for use in accordance with the present invention also may be prepared in accordance with the stoichiometric formulae (A₁₋ₓBₓ)_{y}CuₓO_{w}, where A is one or more elements of Group Illa of the Japanese Periodic Table, e.g. the rare earth elements, B is one or more elements of Group Ila of the Japanese Periodic Table, e.g. the alkaline earth metals including beryllium and magnesium, and 0<x<1; y=2.0-4.0, preferably 2.5-3.5; z=1.0-4.0, preferably 1.5-3.5; and w=4.0-10.0, preferably 6.0-8.0. One example is YBa₂Cu₃O₆₋₈. Also, complex oxide superconducting ceramics for use in accordance with the present invention may be prepared in accordance with the stoichiometric formulae (A₁₋ₓBₓ)_{y}Cu_{z}O_{w}, where A is one or more elements of Group Vb of the Japanese Periodic Table such as Bi, Sb and As, B is one or more elements of Group Ila of the Japanese Periodic Table, e.g. the alkaline earth metals including beryllium and magnesium, and x=0.3-1; y=2.0-4.0, preferably 2.5-3.5; z=1.0-4.0, preferably 1.5-3.5; and w=4.0-10.0, preferably 6.0-8.0. Examples of this general formula are BiSrCaCuCu₂Oₓ and Bi₄Sr₃Ca₃Cu₄Oₓ. Tc onset and Tco for certain samples confirmed consistent with the formula Bi₄Sr_{y}Ca₃Cu₄Oₓ (y around 1.5) were measured to be 40-60 K, which is not particularly high. Relatively high critical temperatures were obtained with samples conforming to the stoichiometric formulae Bi₄Sr₄Ca₂Cu₄Oₓ and Bi₂Sr₃Ca₂Cu₂Oₓ. The number x designating the oxygen proportion being of the order of 6-10, e.g. around 8.1.

While a description has been made for a number of embodiments, the scope of the present invention is to be determined by the appended claims and is not limited by the particular examples. For example the scope of the invention is intended to encompass superconducting ceramic films formed by MBE (Electron Beam Epitaxial Growth), by deposition from the vapour phase, by printing and so forth as well as films formed by sputtering.

## Claims

1. A device comprising a high-Tc superconductive copper oxide ceramic film (2) formed on a substrate (1) and in which at least one region (11) of the film (2) contains partially oxidated, ion implanted, impurity dopant which provides the impurity doped region with an electrical resistivity : temperature characteristic different from that of the non-doped film so that the impurity doped region (11) can exhibit a finite resistivity at a temperature at which the non-doped superconductive ceramic film (2) has zero resistance, there being no ion implantation damage to the crystalline structure of the film in the inpurity doped region.

2. A device as claimed in claim 1 wherein the doping of said region (11) is such that it retains its superconductive nature but with a reduced Tco as compared to the non-doped film.

3. A device as claimed in claim 2 wherein Tc onset for said doped region (11) is substantially unchanged as compared to the non-doped film.

4. A device as claimed in any preceding claim wherein said substrate (1) comprises a semiconductor substrate.

5. A device as claimed in claim 4 wherein said semiconductor substrate (1) contains semiconductor devices interconnected by superconductive circuitry defined in said superconductive ceramic film (2).

6. A device as claimed in claim 5 wherein the circuitry defined in said superconductive ceramic film (2) includes at least one resistance constituted by a said doped region (11) of the film (2).

7. A device as claimed in any preceding claim wherein said superconductive ceramic film conforms to the stoichiometric formula (A₁₋ₓBₓ)_{y}Cu_{z}O_{w} where A comprises one or more elements of Groups IIIa and/or Vb of the Japanese Periodic Table, and B comprises one or more elements of Group IIa of the Japanese Periodic Table.

8. A device as claimed in any of the preceding claims wherein said impurity comprises one or more of Si, Al, Mg, Ga, Ge, Ti, Zr, Fe, Ni, Co, B and P.

9. A device as claimed in any of the preceding claims wherein the impurity density of the dopant is from 5 x 10¹⁵ to 2 x 10²² atom/cm³.

10. A method of manufacturing a device comprising a high-Tc superconductive copper oxide ceramic film (2) formed on a substrate (1) and wherein at least one region (11) of the film has an electrical resistivity : temperature characteristic different from that of another region (10) of the film such that the first-mentioned region (11) can exhibit a finite resistivity at a temperature at which the other region (10) has zero resistance, the method comprising forming the superconductive copper oxide ceramic film (2) on the substrate (1), defining said at least one region (11) of the film, and introducing an oxidizable impurity dopant into said at least one region (11) and not into said other region (10), the doping being effected by ion implantation and being followed by thermal annealing of the film (2) in an oxidizing atmosphere to cause the dopant to be partially oxidated in the film and to make good any ion implantation damage to the crystalline structure of the film in the impurity doped region, whereby to achieve the required electrical resistivity : temperature characteristic.

11. A method as claimed in claim 10 wherein the formation of the superconductive ceramic film (2) on the substrate (1) includes the sputtering onto the substrate of a material having a composition appropriate for the formation of a superconductive film.

12. A method as claimed in claim 10 wherein the formation of the superconductive ceramic film (2) on the substrate (1) includes deposition by printing, by MBE growth or from the vapour phase of a material having a composition appropriate for the formation of a superconductive film onto the substrate.

13. A method as claimed in claim 10 or 11 or 12 wherein the film that is formed on the substrate is patterned for defining active and/or passive superconductive devices.

14. A method as claimed in claim 13 wherein the substrate (1) comprises a semiconductor substrate having one or more semiconductor devices formed therein and the patterning of the superconductive film (2) is effected for defining active and/or passive superconductive devices adapted to interact with said one or more semiconductor devices.

15. A method as claimed in any of claims 10 to 14 wherein said superconductive ceramic film conforms to the stoichiometric formula (A₁₋ₓBₓ)_{y}Cu_{z}O_{w} where A comprises one or more elements of Groups IIIa and/or Vb of the Japanese Periodic Table, and B comprises one or more elements of Group IIa of the Japanese Periodic Table.

16. A method as claimed in any of claims 10 to 15 wherein said impurity comprises one or more of Si, Al, Mg, Ga, Ge, Ti, Zr, Fe, Ni, Co, B and P.

17. A method as claimed in any of claims 10 to 16 wherein the doping of said at least one region (11) of said superconductive ceramic film is effected so as to obtain non-superconductive properties in said doped region (11).

18. A method as claimed in any of claims 10 to 16 wherein the doping of said at least one region (11) of said superconductive ceramic film is effected so that both the doped and non-doped regions of the film exhibit superconductive characteristics but the doped region has a Tco lower than that of the non-doped region.

## Patentansprüche

1. Vorrichtung mit einem auf einem Substrat (1) ausgebildeten, hoch-Tc-supraleitenden, Kupferoxid-Keramikfilm (2), bei der mindestens ein Bereich (11) des Films (2) eine teilweise oxidierte, ionenimplantierte Fremdstoffdotierung enthält, die einen Fremdstoff-dotierten Bereich mit einer Charakteristik elektrischer Widerstand : Temperatur ergibt, die sich von der des undotierten Films unterscheidet, so daß der Fremdstoffdotierte Bereich (11) bei einer Temperatur, bei der der undotierte, supraleitende Keramikfilm (2) keinen Widerstand aufweist, einen endlichen Widerstand aufweisen kann, wobei es in dem Fremdstoff-dotierten Bereich keine Ionenimplantationsschäden an der Kristallstruktur des Films gibt.

2. Vorrichtung nach Anspruch 1, bei der die Dotierung des Bereichs (11) eine solche ist, daß dieser seine supraleitende Eigenschaft beibehält, jedoch mit verringerter Tco im Vergleich zum undotierten Film.

3. Vorrichtung nach Anspruch 2, bei der die Einsatztemperatur Tc für den dotierten Bereich (11) im Vergleich zu der des undotierten Films im wesentlichen unverändert ist.

4. Vorrichtung nach einem der vorstehenden Ansprüche, bei der das Substrat (1) ein Halbleitersubstrat aufweist.

5. Vorrichtung nach Anspruch 4, bei der das Halbleitersubstrat (1) Halbleiterbauelemente enthält, die durch ein supraleitendes Schaltungssystem miteinander verbunden sind, wie es im supraleitenden Keramikfilm (2) festgelegt ist.

6. Vorrichtung nach Anspruch 5, bei der das im supraleitenden Keramikfilm (2) festgelegte Schaltungssystem mindestens einen durch einen dotierten Bereich (11) des Films (2) gebildeten Widerstand aufweist.

7. Vorrichtung nach einem der vorstehenden Ansprüche, bei der der supraleitende Keramikfilm der stöchiometrischen Formel (A₁₋ₓBₓ)_{y}Cu_{z}O_{w} genügt, wobei A eines oder mehrere Elemente der Gruppe IIIa und/oder Vb des japanischen Periodensystems aufweist und B eines oder mehrere Elemente der Gruppe IIa des japanischen Periodensystems aufweist.

8. Vorrichtung nach einem der vorstehenden Ansprüche, bei der der Fremdstoff eine oder mehrere der Substanzen Si, Al, Mg, Ga, Ge, Ti, Zr, Fe, Ni, Co, B und P umfaßt.

9. Vorrichtung nach einem der vorstehenden Ansprüche, bei der die Fremdstoffdichte des Dotierstoffs von 5 x 10¹⁵ bis 2 x 10²² Atome/cm³ reicht.

10. Verfahren zum Herstellen einer Vorrichtung mit einem auf einem Substrat (1) ausgebildeten hoch-Tc-supraleitenden Kupferoxid-Keramikfilm (2), wobei mindestens ein Bereich (11) des Films eine Charakteristik elektrischer Widerstand : Temperatur aufweist, die sich von der eines anderen Bereichs (10) des Films in solcher Weise unterscheidet, daß der erstgenannte Bereich (11) bei einer Temperatur, bei der der andere Bereich (10) keinen Widerstand aufweist, einen endlichen Widerstand aufweisen kann, welches Verfahren es umfaßt, den supraleitenden Kupferoxid-Keramikfilm (2) auf dem Substrat (1) auszubilden, den mindestens einen Bereich (11) auf dem Film festzulegen und eine oxidierbare Fremdstoffdotierung in den mindestens einen Bereich (11) und nicht in den anderen Bereich (10) einzubringen, wobei die Dotierung durch Ionenimplantation bewirkt wird, dem thermisches Tempern des Films (2) in einer oxidierenden Atmosphäre folgt, um die Dotierung teilweise in dem Film zu oxidieren und um irgendeinen Ionenimplantationsschaden an der Kristallstruktur des Films in dem Fremdstoff-dotierten Bereich auszugleichen, um dadurch die erforderliche Charakteristik elektrischer Widerstand : Temperatur zu erzielen.

11. Verfahren nach Anspruch 10, bei dem zum Ausbilden des supraleitenden Karamikfilms (2) auf dem Substrat (1) das Sputtern eines Materials auf das Substrat gehört, das eine Zusammensetzung aufweist, die für die Ausbildung eines supraleitenden Films geeignet ist.

12. Verfahren nach Anspruch 10, bei dem zur Ausbildung des supraleitenden Keramikfilms (2) auf dem Substrat (1) das Abscheiden eines Materials mit einer Zusammensetzung, die für das Ausbilden eines supraleitenden Films auf dem Substrat geeignet ist, durch Drucken, durch MBE-Wachstum oder aus der Gasphase gehört.

13. Verfahren nach einem der Ansprüche 10, 11 oder 12, bei dem der auf dem Substrat auszubildende Film gemustert wird, um aktive und/oder passive supraleitende Bauelemente festzulegen.

14. Verfahren nach Anspruch 13, bei dem das Substrat (1) ein Halbleitersubstrat mit einem oder mehreren in diesem ausgebildeten Halbleiterbauelementen aufweist, und das Mustern des supraleitenden Films (2) ausgeführt wird, um aktive und/oder passive supraleitende Bauelemente festzulegen, die so ausgebildet sind, daß sie mit dem einen oder mehreren Halbleiterbauelementen wechselwirken.

15. Verfahren nach einem der Ansprüche 10 bis 14, bei dem der supraleitende Keramikfilm der stöchiometrischen Formel (A₁₋ₓBₓ)_{y}Cu_{z}O_{w} genügt, wobei A eines oder mehrere Elemente der Gruppe IIIa und/oder Vb des japanischen Periodensystems aufweist und B eines oder mehrere Elemente der Gruppe IIa des japanischen Periodensystems aufweist.

16. Verfahren nach einem der Ansprüche 10 bis 15, bei dem zum Fremdstoff einer oder mehrere der Stoffe Si, Al, Mg, Ga, Ge, Ti, Zr, Fe, Ni, Co, B und P gehört.

17. Verfahren nach einem der Ansprüche 10 bis 16, bei dem das Dotieren des mindestens einen Bereichs (11) des supraleitenden Keramikfilms so ausgeführt wird, daß in diesem dotierten Bereich (11) nichtsupraleitende Eigenschaften erhalten werden.

18. Verfahren nach einem der Ansprüche 10 bis 16, bei dem das Dotieren des mindestens einen Bereichs (11) des supraleitenden Keramikfilms so ausgeführt wird, daß die dotierten und die undotierten Bereiche des Films Supraleitungseigenschaften aufweisen, daß jedoch der dotierte Bereich eine tiefere Tco als der undotierte Bereich aufweist.

## Revendications

1. Dispositif comprenant un film (2) en céramique à oxyde de cuivre supraconductrice à Tc élevée, formé sur un substrat (1) et dans lequel au moins une région (11) du film (2) contient un dopant formé d'impureté ayant subi une implantation d'ions et partiellement oxydé, qui confère à la région dopée de l'impureté une caractéristique résistivité électrique/température différente de celle du film non dopé de sorte que la région (11) dopée de l'impureté puisse présenter une résistivité finie à une température à laquelle le film (2) en céramique supraconductrice non dopé présente une résistance nulle, sans que l'implantation d'ions n'endommage la structure cristalline du film dans la région dopée d'impureté.

2. Dispositif selon la revendication 1 dans lequel le dopage de ladite région (11) est telle qu'elle conserve sa nature supraconductrice mais avec une valeur Tco réduite par comparaison avec le film non dopé.

3. Dispositif selon la revendication 2 dans lequel le point d'apparition de Tc pour ladite région dopée (11) est sensiblement inchangé par comparaison avec le film non dopé.

4. Dispositif selon l'une quelconque des revendications précédentes dans lequel ledit substrat (1) est un substrat à semi-conducteur.

5. Dispositif selon la revendication 4 dans lequel ledit substrat à semi-conducteur (1) contient des dispositifs à semi-conducteur interconnectés par des circuits supraconducteurs définis dans ledit film (2) en céramique supraconductrice.

6. Dispositif selon la revendication 5 dans lequel les circuits définis dans ledit film (2) en céramique supraconductrice comprennent au moins une résistance constituée par une dite région dopée (11) du film (2).

7. Dispositif selon l'une quelconque des revendications précédentes, dans lequel ledit film en céramique supraconductrice est conforme à la formule stoechiométrique (A₁₋ₓBₓ)_{y}Cu_{z}d_{w} où A représente un ou plusieurs éléments des groupes IIIa et/ou Vb du tableau périodique japonais, et B représente un ou plusieurs éléments du groupe IIa du tableau périodique japonais.

8. Dispositif selon l'une quelconque des revendications précédentes dans lequel ladite impureté comprend un ou plusieurs des éléments Si, Al, Mg, Ga, Ge, Ti, Zr, Fe, Ni, Co, B et P.

9. Dispositif selon l'une quelconque des revendications précédentes dans lequel la densité de l'impureté du dopant est de 5 x 10¹⁵ à 2 x 10²² atomes/cm³.

10. Procédé de fabrication d'un dispositif comprenant un film (2) en céramique à oxyde de cuivre supraconductrice et à Tc élevée, formé sur un substrat (1) et dans lequel au moins une région (11) du film présente une caractéristique résistivité électrique/température différente de celle d'une autre région (10) du film, de sorte que la région (11) mentionnée en premier puisse présenter une résistivité finie à une température à laquelle l'autre région (10) présente une résistance nulle, le procédé comprenant la formation du film (2) en céramique à oxyde de cuivre supraconductrice sur le substrat (1), la définition de ladite région (11) au nombre d'au moins une du film et l'introduction d'un dopant formé d'impureté oxydable dans ladite région (11) au nombre d'au moins une et non pas dans ladite autre région (10), le dopage étant effectué par implantation d'ions et suivi d'un recuit thermique du film (2) dans une atmosphère oxydante pour provoquer l'oxydation partielle du dopant dans le film et réparer tout dommage provoqué par l'implantation d'ions à la structure cristalline du film dans la région dopée par l'impureté, de manière à obtenir la caractéristique résistivité électrique/température requise.

11. Procédé selon la revendication 10 dans lequel la formation du film (2) en céramique supraconductrice sur le substrat (1) comprend la pulvérisation cathodique sur le substrat d'une matière dont la composition est appropriée à la formation d'un film supraconducteur.

12. Procédé selon la revendication 10 dans lequel la formation du film (2) en céramique supraconductrice sur le substrat (1) comprend le dépôt par impression, par croissance MBE ou en phase vapeur d'une matière dont la composition est appropriée à la formation d'un film supraconducteur sur le substrat.

13. Procédé selon la revendication 10, 11 ou 12 dans lequel au film qui est formé sur le substrat est conféré un motif afin de définir des dispositifs supraconducteurs actifs et/ou passifs.

14. Procédé selon la revendication 13 dans lequel le substrat (1) comprend un substrat à semi-conducteur dans lequel sont formés un ou plusieurs dispositifs à semi-conducteur et le motif est conféré au film supraconducteur (2) pour définir des dispositifs supraconducteurs actifs et/ou passifs adaptés pour coopérer avec ledit ou lesdits dispositif(s) à semi-conducteur.

15. Procédé selon l'une quelconque des revendications 10 à 14 dans lequel ledit film en céramique supraconductrice est conforme à la formule stoechiométrique (A₁₋ₓBₓ)_{y}Cu_{z}O_{w} où A représente un ou plusieurs éléments des groupes IIIa et/ou Vb du tableau périodique japonais, et B représente un ou plusieurs éléments du groupe IIa du tableau périodique japonais.

16. Procédé selon l'une quelconque des revendications 10 à 15 dans lequel ladite impureté comprend un ou plusieurs des éléments SI, Al, Ga, Ge, Ti, Zr, Fe, Ni, Co, B et P.

17. Procédé selon l'une quelconque des revendications 10 à 16 dans lequel le dopage de ladite région (11) au nombre d'au moins une dudit film en céramique supraconductrice est effectué de manière à obtenir des propriétés de non supraconductivité dans ladite région dopée (11).

18. Procédé selon l'une quelconque des revendications 10 à 16 dans lequel le dopage de ladite région (11) au nombre d'au moins une dudit film en céramique supraconductrice est effectué de manière à ce que les régions dopées aussi bien que les régions non dopées du film présentent des caractéristiques de supraconductivité mais à ce que la région dopée présente une valeur Tco inférieure à celle de la région non dopée.
